Europäisches Patentamt

(19) European Patent Office

Office européen des brevets

(11) Veröffentlichungsnummer: **0 052 669**
**B1**

# (12) EUROPÄISCHE PATENTSCHRIFT

(45) Veröffentlichungstag der Patentschrift:
27.03.85

(21) Anmeldenummer: 80107368.5

(22) Anmeldetag: 26.11.80

(51) Int. Cl.⁴: **G 06 F  13/00**, G 11 C  8/00,
G 11 C  11/40, H 03 K  3/286

(54) Mehrfach adressierbarer hochintegrierter Halbleiterspeicher.

(43) Veröffentlichungstag der Anmeldung:
02.06.82 Patentblatt 82/22

(45) Bekanntmachung des Hinweises auf die Patenterteilung:
27.03.85 Patentblatt 85/13

(84) Benannte Vertragsstaaten:
CH DE FR GB IT LI NL

(56) Entgegenhaltungen:
EP - A - 0 031 488
FR - A - 2 357 979
US - A - 3 651 476
US - A - 3 737 866
US - A - 3 968 480
US - A - 3 979 735
US - A - 4 070 657
US - A - 4 125 877
US - A - 4 127 899
US - A - 4 193 127

IBM TECHNICAL DISCLOSURE BULLETIN, Band 23, Nr. 2, Juli 1980, Seiten 657-658 Armonk, U.S.A. C.A. PRICE: "Simultaneous access memory"
PROCEEEDINGS OF THE IFAC/IFIP SYMPOSIUM, 21. - 23. Oktober 1965, Seiten 259-273 München, DE. H. STOPPER et al.: "Eine integrierte Schlatung zur Rallsierung eines Halbleiterspeichers"
IBM TECHNICAL DISCLOSURE BULLETIN, Band 22, Nr. 10, März 1980, Seiten 4553-4554 Armonk, U.S.A. R.T. DENNISON et al.: "Multi-port array cell"

(56) Entgegenhaltungen: (Fortsetzung)
IEEE TRANSACTIONS ON COMPUTERS, Band C.29, Nr. 8, August 1980, Seiten 689-694 New York, U.S.A. S.S.L. CHANG: "Multiple-read single-write memory and its applications"
PROCEEDINGS OF THE FALL JOINT COMPUTER CONFERENCE, Band 29, 7. - 10. November 1966, AFIPS Seiten 315-331 San Francisco, U.S.A. I. CATT et al.: "A high-speed integrated circuit scratchpad memory"
IBM TECHNICAL DISCLOSURE BULLETIN, Band 22, Nr. 4, September 1979, Seiten 1489-1492 Armonk, U.S.A. E.J. CRETELLI et al.: "Dual Schottky diode cell"
IBM TECHNICAL DISCLOSURE BULLETIN, Band 23, Nr. 1, Juni 1980, Seiten 180-186 Armonk, U.S.A. J.R. CAVALIERE et al.: "Memory cell adapted for different combinations of simultaneous read and write operations"
IBM Technical Disclosure Bulletin, Vol. 19, No. 7, Dec. 1976, p. 2587-2589

(73) Patentinhaber: IBM DEUTSCHLAND GMBH, Pascalstrasse 100, D-7000 Stuttgart 80 (DE)

(84) Benannte Vertragsstaaten: DE

(73) Patentinhaber: International Business Machines Corporation, Old Orchard Road, Armonk, N.Y. 10504 (US)

(84) Benannte Vertragsstaaten: CH FR GB IT LI NL

(72) Erfinder: Berger, Horst, Dr., Eltinger Strasse 2, D-7032 Sindelfingen (DE)
Erfinder: Wiedmann, Siegfried, Dr., Im Himmel 64A, D-7000 Stuttgart 80 (DE)

(74) Vertreter: Rudolph, Wolfgang, Dipl.-Ing., Schönalcher Strasse 220, D-7030 Böblingen (DE)

## Beschreibung

Die Erfindung betrifft einen mehrfach adressierbaren hochintegrierten Halbleiterspeicher gemäß Oberbegriff des Patentanspruchs 1.

Speicher, die ein paralleles Auslesen von zwei gespeicherten Worten ermöglichen oder gleichzeitig ein Lesen eines bestimmten eingespeicherten Wortes und ein Einschreiben eines anderen Wortes in einem anderen Speicherplatz eines Speichers ermöglichen, sind prinzipiell bekannt.

Ein Halbleiterspeicher, der ein gleichzeitiges Ansteuern von zwei oder mehr als zwei Wortleitungen erlaubt, ist in der DE-OS 2 327 062 beschrieben. Dieser Speicher hat jedoch den Nachteil, daß die ausgelesenen Wörter nicht gleichzeitig am Ausgang des Speichers zur Verfügung stehen, sondern innerhalb des Speichers zu einem logischen Produkt miteinander verknüpft werden. Ein gleichzeitiges Einschreiben eines Wortes in andere Speicherplätze ist außerdem nicht möglich.

Außerdem ist aus der US-PS 3 675 218 eine Speicheranordnung bekannt, bei der Informationen in jeden beliebigen Teil eingeschrieben werden kann, während gleichzeitig Information aus einem anderen, davon verschiedenen Teil der Anordnung ausgelesen wird. Auch hier ist also trotz der sehr technisch aufwendigen Lösung nur ein Einschreiben eines Wortes bei gleichzeitigem Auslesen eines anderen Wortes möglich. Im IBM-TDB, Vol. 19, Nr. 7, Dezember 1976, Seiten 2587—2589 ist eine Speicherorganisation beschrieben, die ein paralleles Auslesen von zwei gespeicherten Worten dadurch erlaubt, daß den Speicherelementen Koppelglieder zugeordnet sind, die jedoch in integrierter Technik sehr viel Platz benötigen.

Aus IEEE/1977, Seiten 72 und 73, »International Solid State Circuit Conference«, 16. Febr. 1977 ist ein 32 · 9 ECL Dualadreßregister bekannt, das zwei parallele getrennte Leseoperationen von gespeicherten Worten erlaubt. Der technische Aufwand zur Abfühlung und Selektion sowie zum Einschreiben ist relativ hoch und erlaubt keine optimale Integration.

Außerdem ist aus der US-A-4 125 877 ein zweifach adressierbarer Speicher bekannt, dessen Speicherzellen aus zwei Einzelspeicherelementen bestehen. Diese zwei Einzelspeicherelemente werden über getrennte Adressierungsschaltungen adressiert, so daß ein paralleles Lesen und Schreiben, ein paralleles Schreiben oder ein paralleles Lesen möglicht ist. Da diese Zellen jedoch untereinander rückgekoppelt sind, wird zwangsläufig beim Auslesen immer die Information in die andere Zelle geschrieben. Bedingt dadurch weist diese Zelle zur Selektion außerdem getrennte Wortleitungen für jede Einzelzelle auf. Da jedoch auch noch Rückkopplungsleitungen vorhanden sind, ist die Anzahl der Ansteuerleitungen zusammen mit den Wort- und Bitleitungen sehr hoch, so daß abgesehen von der Problematik im praktischen Betrieb eine Integration einer derart aufgebauten Speicherzelle in einem hochintegrierten Speicher sehr nachteilig ist. Außerdem weist eine derartige Zelle den Nachteil auf, daß nur zwei getrennte Zugänge vorhanden sind und daß diese Zelle nicht durch Hinzufügen von Zugängen auf Drei- oder Mehrwortspeicher-Zellen ausgebaut werden kann.

Die bereits beschriebenen parallel adressierbaren Speicher haben alle den gemeinsamen Nachteil, daß sie noch nicht geeignet sind, in modernen Prozessoren als sehr schnelle Speicher ohne Zusatzregister bzw. Speicher eingesetzt werden zu können. In modernen Prozessoren sind in der Regel schnelle Register vorhanden, die teils verborgen arbeiten und teils dem Programmierer zur Verfügung stehen. Bei vielen Instruktionen werden zwei Operanden aus zwei verschiedenen Registern gelesen und dem Rechenwerk zur Verarbeitung zugeführt; das Ergebnis dieser Rechenoperation wird dann wieder in einem der Register gespeichert. Bei der Ausführung einer Instruktion in einem derartig bekannten Prozessor ist folgender Ablauf üblich:

1. Auslesen von zwei Operanden aus verschiedenen Registern,
2. Ausführung einer arithmetischen Operation, wie z. B. Addition, Subtraktion oder Multiplikation,
3. Rückführung des Ergebnisses in eines der Register, d. h., das Ergebnis wird in eines der Register eingeschrieben.

Hinzu kommt oft noch der Wunsch, eine Zeitlücke zu finden, in der andere neue Informationen, z. B. aus dem Hauptspeicher, in eines der Register geschrieben werden muß. Bei den bisher bekannten Speichern, die die Adressierung nur eines Wortes erlauben bzw. die parallele Adressierung nur eines Wortes erlauben bzw. die parallele Adressierung nur zum Leser zweier Wörter erlauben, können solche Operationen immer nur seriell oder teilparallel ausgeführt werden. Damit reihen sich zum Schluß Zeiten des Speichers aneinander und bestimmen im wesentlichen die Geschwindigkeit, mit der eine Instruktion ausgeführt werden kann. Um die Operationen zu beschleunigen, wäre deshalb ein Speicher wünschenswert, der parallel benutzbare Zugänge zu den einzelnen Registern hat, nämlich für den vorliegenden Fall möglichst drei Zugänge und zwar für den Operand einen Leseausgang und für das Ergebnis einen Schreibeingang. Um dese Zugänge zu den Registern ansteuern zu können, gehört zu jedem einzelnen Zugang ein unabhängiger Adreßdecoder. Aus der oben angegebenen Literatur (IEEE von 1977) sind nun, wie beschrieben, Registerbänke mit zwei Zugängen bekannt. Bei Ausführung in hochintegrierter Halbleitertechnik, insbesondere in bipolarer Halbleitertechnik ist es aber relativ schwierig und aufwendig, mit nur einer Speicherzelle pro Bit auszukommen. In der Regel werden deshalb entsprechend den beiden Adreßsystemen zwei Zellen pro Bit verwendet, die aber immer gleiche Information tragen müssen. Es muß immer sichergestellt sein, daß eine Information, die über ein Adreßsystem in eine Zelle des Paares geschrieben wird, auch in die andere Zelle des Paares gelangt. Gemäß der Ausführung in der genannten Literaturstelle wird das dadurch erreicht, daß im Ruhezustand die Zellpaare gekoppelt sind, d. h., daß erst nach dem Schreiben einer Zelle, nämlich beim Übergehen in den Ruhezustand über die Kopplung die gleiche Information in die andere Zelle des Paares eingeprägt wird. Ein dritter Zugang fehlt diesem Speicher völlig.

Der im Patentanspruch 1 gekennzeichneten Erfindung liegt deshalb die Aufgabe zugrunde, einen hochintegrierten Halbleiterspeicher zu schaffen, der mindestens drei Zugänge mit jeweils unabhängigen Adreßdecodern besitzt, um mindestens drei Operationen, wie z. B. Lesen eines Wortes A, Lesen eines Wortes B und Schreiben eines Wortes C sowie jede beliebige Zweierkombination oder einzelne der drei Operationen parallel ausführen zu können und der die übliche Speicher- und Register-Hierarchie in den Prozessoren vermeidet.

Weitere Ausgestaltungen der Erfindung sind in den Patentansprüchen 2 bis 7 charakterisiert.

Durch die Schaffung eines dritten Zugangs zu jeder Speicherzelle und die Anwendung von Doppelzellen oder Mehrfachzellen zu einer wortorganisierten Speichermatrix, ist es möglich, das Auslesen zweier oder mehrerer Operanden parallel vorzunehmen und danach das Einschreiben des Ergebnisses in denselben Speicher sofort durchzuführen, ohne daß Zwischenregister oder sonstige Hilfsmittel erforderlich sind. Die Doppel- oder Mehrfachzellenstruktur hat gegenüber den bisher bekannten Speichern den Vorteil, daß trotz der zusätzlichen Zugänge eine wesentlich bessere und höhere Integration erreicht wird. Die Schreib- und Leseselektion über Koppelglieder ermöglicht es, daß die Zellen auf verschiedene Polarität der Veränderung des Bezugspotentials ansprechen, wodurch die Möglichkeit der separaten Optimierung der Schreib- und Lesegeschwindigkeit der Zellen erzielt wird. Außerdem ist die beliebige Erweiterungsmöglichkeit der Anzahl der Lesezugänge über weitere Adreßsysteme und Triple-, Quadrupel usw. Speicherzellen technisch sehr einfach realisierbar.

Die Erfindung wird nun anhand von in den Zeichnungen dargestellten Ausführungsbeispielen näher beschrieben. Es zeigt

Fig. 1 die prinzipielle Anordnung der Zellenpaare innerhalb einer Speichermatrix;

Fig. 2 eine Ausführung einer Speicherzelle eines Paares mit Koppeldioden;

Fig. 3 eine Anordnung zweier Speicherzellen innerhalb des Speichersystems;

Fig. 4 eine besonders vorteilhafte Ausführung der in den Fig. 1 und 2 dargestellten Speicherzellen; und

Fig. 5 ein Layout eine Doppelzelle, die ein paralleles Lesen zweier Wörter und das Einschreiben eines weiteren Wortes ermöglicht.

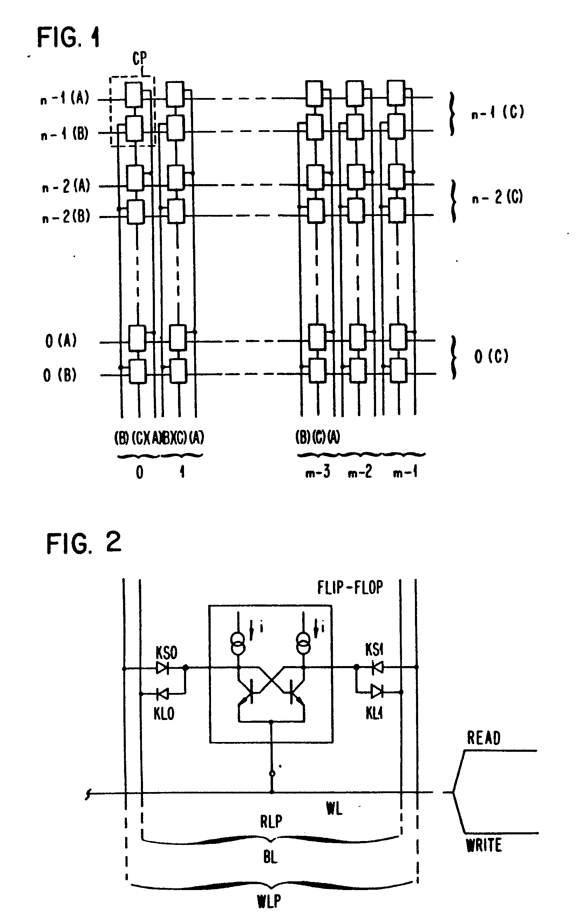

Ein Ausschnitt aus einer Speichermatrix, in deren Kreuzungspunkten von Wortleitungen und Bitleitungen Speicherzellen angeordnet sind und in der zwei Speicherzellen zur Speicherung eines Bits ein Zellenpaar CP bilden, ist in Fig. 1 dargestellt. Dieser Speicher besitzt drei Zu-/Abgänge (A), (B) und (C), wodurch dann im Betrieb folgende Speicheroperationen jeweils parallel für unterschiedliche Adressen möglich sind:

Lesen A, Lesen B, Schreiben C

und jede beliebige Zweierkombination der drei Operationen oder eine einzelne Operation davon.

Jeder Speicherplatz wird durch ein Zellenpaar CP gebildet, wobei eine Zelle zum Lesen dem Adreßsystem A und die andere dem Adreßsystem B zugeordnet ist. Beide, das Zellenpaar CP bildende Speicherzellen, sind gemeinsam dem Adreßsystem C zugeordnet, d. h., es wird hier in diesem Ausführungsbeispiel parallel eingeschrieben, während dem die Speicherzugänge (A) und (B) zum getrennten Lesen gespeicherter Informationen dienen. Das Zellenpaar CP aus zwei Flip-Flops ist nur für das vorliegende Ausführungsbeispiel gewählt. Anstatt der zwei je eine Speicherzelle bildenden Flip-Flops, sind auch andere Ausführungen von mehreren Speicherelementen, wie z. B. eine dynamische Ein-FET-Zelle ohne weiteres anwendbar. Bei drei Speicherelementen pro Speicherplatz sind drei Leseleitungen jeweils über Koppelelemente an die Speicherelemente gekoppelt.

Logisch werden in alle Speicherelemente, hier drei, stets die gleichen Informationen eingeschrieben. In physikalischen Ausführungen kann es vorteilhaft sein, die gemeinsame Schreibleitung in zwei oder mehrere Leitungen aufzuspalten, um z. B. die Speicherelemente der Speicherplätze in physikalisch getrennten Matrizen ausführen zu können.

Zur Vereinfachung der Darstellung wurden die Adreßdecodierer in der Zeichnung weggelassen, wobei jedoch betont werden muß, daß jeder Zugang des Speichers seinen eigenen Adreßdecoder besitzt, der wie die bekannten Adreßdecoder aufgebaut sein kann. Wird nun in dem Speicher nach Fig. 1 ein Register über den zum Zugang (A) gehörigen, nicht dargestellten Adreßdecoder, abgefragt, dann werden nur die zugehörigen Zellen der Bitzellenpaare CP selektiert, die zu der Wortleitung gehören, die mit dem Zugang (A) verbunden sind. Im vorliegenden Falle sind dies die Register n − 1 (A), n − 2 (A), ... Außerdem werden die vertikalen Bitleitungsausgänge, die mit (A) bezeichnet sind, aktiv. Es kann aber durchaus gleichzeitig über den Zugang (B) eine mit ihm verbundene Wortleitung sogar der gleichen Adresse selektiert werden, wobei die Bitleitungsausgänge (B) zusätzlich aktiv werden.

Zum Einschreiben einer Information in diesen Speicher gemäß diesem Ausführungsbeispiel ist nur ein Bitzugang (C) pro Zellenpaar CP vorhanden und auch die Wortleitungen einer Adresse werden gemeinsam angesteuert, so daß mit Sicherheit beide Zellen eines Zellenpaares CP den gleichen Informationsstatus erhalten.

In einem weiteren, weiter unten beschriebenen Ausführungsbeispiel wird gezeigt, daß man ein Wort über den Zugang (C) schreiben kann, während gleichzeitig ein oder zwei andere Worte unabhängig über die Zugänge (A) oder (B) ausgelesen werden. Gleichzeitiges Lesen und Schreiben derselben Speicherzelle ist jedoch nicht möglich. Die Koinzidenz der Adressen A mit C oder B mit C bedeutet nichts anderes, als daß die über die Zugänge A oder B gewünschte Information außerhalb des Speichers, nämlich am Zugang C anliegt und direkt dort verfügbar ist.

In Fig. 2 ist zunächst nur eine der beiden Zellen eines Zellenpaares CP gezeigt, wobei der Kern aus einem an sich bekannten Flip-Flop gebildet wird.

Die Unterscheidung einer Schreib- und einer Leseselektion an der Wortleitung WL wird, wie in Fig. 2 dargestellt, durch die Bitleitungskoppelglieder KL0 und KL1 mit verschiedener Durchlaßrichtung erreicht. Aus Fig. 2 ist zu ersehen, daß die Koppelglieder für das Lesen KL0 und KL1 öffnen, wenn das Bezugspotential der Speicherzelle auf der Wortleitung WL angehoben wird. In bekannter Weise erfolgt dadurch eine Selektion gegenüber den übrigen, nicht gezeigten Zellen des gleichen Bits, weil diese negativeres Bezugspotential haben, deren Lesekopplungsglieder also gesperrt sind. Dies bedeutet aber auch, daß ein noch negativeres Potential an einer der übrigen Zellen dieser Bitleitung RLP diese Leseselektion nicht stört.

Dieses einzelne negativere Potential an einer der anderen, nicht dargestellten Wortleitungen, schaltet aber die Schreibkoppelglieder KS0 oder KS1 ein, so daß in diese Zelle selektiv und gleichzeitig mit dem Lesen der anderen Zelle über das andere Bitleitungspaar WLP Informationen eingeschrieben werden kann. Eine Umkehrung der Diodendurchlaßrichtungen und die zugehörige Umkehrung der Schreib- und Lese-Wortleitungspolarität ist selbstverständlich auch möglich, ohne daß das Konzept der Erfindung verlassen wird.

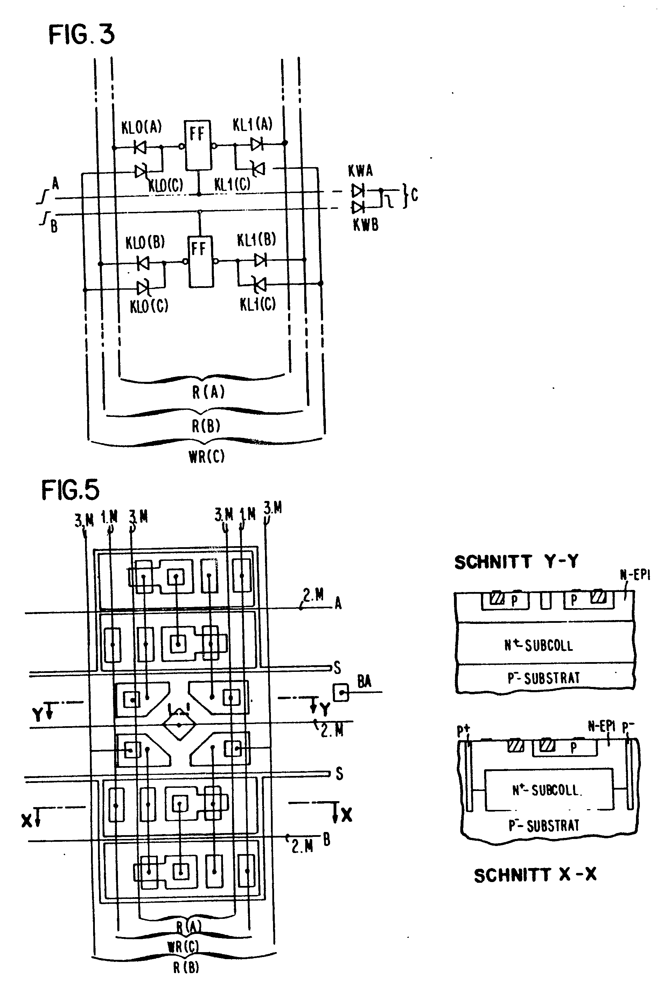

Ein paralleles Lesen zweier Wörter wird erreicht, indem die Zellen jedes Bits dupliziert werden und ein eigenes Zugangssystem (Wort- und Lese-Bitleitungen) erhalten. Wie bereits weiter oben ausgeführt worden ist, existiert auch hier nur ein Schreibzugang (C), d. h., beide Zellen-Flip-Flops FF des in Fig. 3 dargestellten Zellenpaares werden gleichzeitig über die im Prinzip durch Dioden KWA und KWB dargestellte Kopplung der beiden Wortleitungen A und B und die gemeinsamen Schreibleitungen WR (C) geschrieben. Es muß jedoch hier betont werden, daß durchaus ein anderes Wort über den (A)- oder (B)-Zugang gleichzeitig gelesen werden kann. Lediglich eine Koinzidenz der A- bzw. B-Adresse mit einer C-Adresse muß im vorliegenden Ausführungsbeispiel vermieden werden, indem man z. B. der C-Adresse die Priorität gibt. Die Prioritätssteuerung kann entweder logisch von außen geschehen oder im Speicher selbst, in dem z. B. eine C-Selektion die zugehörigen A- oder B-Selektionen ausschaltet. Da solche Schaltungen im Rahmen des fachmännischen Könnens liegen, wird eine detaillierte Beschreibung einer solchen Schaltung hier nicht angegeben.

Außerdem ist es möglich, die Koinzidenz der Adressen C und A oder C und B an den Decoderausgängen abzufühlen und dadurch ein Steuersignal auszulösen, das den (C)-Eingang auf den (A)- bzw. (B)-Ausgang durchschaltet.

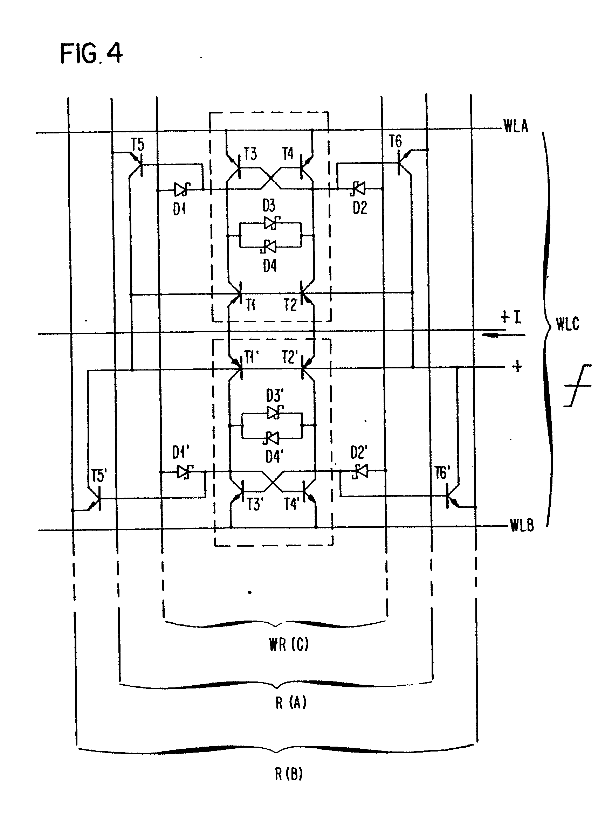

Eine besonders vorteilhafte Schaltungs-Ausführung der in den Fig. 1 bis 3 im Prinzip dargestellten Zellen ist in Fig. 4 detailliert gezeigt. Gestrichelt umrandet sind dabei die beiden Flip-Flops FF gemäß Fig. 3, welche aus PNP-Transistoren T1, T2 bzw. T1' bzw. T2' als Stromquellen aufgebaut sind. Die kreuzgekoppelten NPN-Transistoren T3, T4 bzw. T3' bzw. T4' können in bekannter Weise Schottky-Klemm-Elemente erhalten, was durch die Schottky-Dioden D3 und D4 dargestellt ist, die das Einschreiben einer Information in den Speicher beschleunigen. Als Koppelglieder zu den Schreib-Bitleitungen WR (C) werden im Ausführungsbeispiel ebenfalls Schottky-Dioden D1 und D2 bzw. D1' und D2' verwendet. Für die Lese-Koppelglieder nimmt man jedoch zweckmäßig die Transistoren T5, T6 bzw. T5', T6', weil deren Stromverstärkung ein stärkeres Lesesignal hervorbringt. Dadurch sind die anderen beiden Bitleitungspaare R (A) und R (B) an die Zellen angekoppelt. Die Wortleitung C entspricht der in Fig. 3 und ist deshalb auch in die Leitungen A und B aufgeteilt.

Die Selektion der einzelnen Zellen entspricht der, die im Zusammenhang mit den Fig. 1 bis 3 beschrieben ist, so daß an dieser Stelle kein Selektionsbeispiel angegeben ist.

In Fig. 5 ist eine Realisierung einer erfindungsgemäßen Doppelzellenstruktur in bipolarer Halbleitertechnik gezeigt, wobei davon ausgegangen wird, daß sowohl die Zellenstruktur ansich als auch eine Dreifach-Metallisierung auf einem Chip bekannt sind. Diese drei Metallisierungsschichten sind durch 1.M bis 3.M in Fig. 5 schematisch dargestellt. Die Zellenbreite kann durch diese Dreifach-Metallisierung wesentlich, im Vergleich zur einfachen Metallisierung, verringert werden.

Die Bitleitungspaare sind entsprechend den Fig. 1 bis 4 mit R (A), R (B) und WR (C) gekennzeichnet und entsprechen diesen voll. Auch die beiden Wortleitungen A und B gemäß Fig. 3 sind klar in Fig. 5 zu erkennen. Um die Halbleiterstruktur der eigentlichen Zelle besser zeigen zu können, sind zwei Schnitte, nämlich Schnitt Y-Y und Schnitt X-X rechts dargestellt. Da diese Schnitte selbsterklärend sind, wird auf eine genauere Beschreibung verzichtet. Jedem Zugang (A), (B) und (C) ist hier vorteilhaft eine Metallisierungsebene zugeordnet.

Mit den in den Fig. 1 bis 5 gezeigten Anordnungen von Doppelzellen in einer wortorganisierten Speichermatrix ist es also möglich, daß jeweils eine der Doppelzellen über Ansteuerund Leseleitungen eines Zugangs und die andere separat davon über zweite Ansteuer- und Leseleitungen eines zweiten Zugangs ausgelesen werden kann, wogegen aber das Schreiben durch einen dritten Zugang über, den Zellen eines Speicherzellenpaares CP gemeinsame oder verkoppelte Schreib- bzw. Ansteuerleitung erfolgt. Es wurde auch klar beschrieben, daß die Schreib- und Leseselektion über Koppelglieder erfolgt, die auf verschiedene Polarität der Veränderung des Bezugspotentials der Zellen ansprechen, wodurch die Möglichkeit der separaten Optimierung der Schreib- und Lesegeschwindigkeit der Speicherzellen gegeben ist.

## Patentansprüche

1. Mehrfach adressierbarer hochintegrierter Halbleiterspeicher, dessen über Adreßdecoder ansteuerbare Speicherplätze mit mindestens zwei Einzelspeicherelementen in Kreuzungspunkten von Wort- und Bitleitungspaaren liegen und über mehrere unabhängige Adreßsysteme zum parallelen Lesen und/oder Schreiben ansteuerbar sind, dadurch gekennzeichnet, daß zur Realisierung der Funktionen Lesen und Schreiben die Wort- und Bitleitungspaare über jeweils ein Koppelgliederpaar (KL, (A, B) bzw. KL, (C)) mit den Einzelspeicherelementen (FF) verbunden sind, daß die mit den Bitleitungen für das Lesen verbundenen Koppelglieder durch Anheben bzw. Absenken des Bezugspotentials der Einzelspeicherelemente über eine Ansteuerleitung für das Lesen und die mit den Bitleitungen für das Schreiben verbundenen Koppelglieder durch Absenken bzw. Anheben des Bezugspotentials für Einzelspeicherelemente über eine Ansteuerleitung für das Schreiben geöffnet werden, daß jeweils ein solches Einzelspeicherelement eines Speicherplatzes über Ansteuer- und Leseleitungen (A, R (A)) und das andere Einzelspeicherelement desselben Speicherplatzes separat davon über zweite Ansteuer(B)- und Leseleitungen (R, (B)) zum Auslesen ansteuerbar ist, und daß die Schreiboperation für beide Einzelspeicherelemente eines Speicherplatzes durch mindestens einen dritten Zugang (C) durch Veränderung des Bezugspotentials steuerbar ist, indem die beiden Einzelspeicherelemente eines Speicherplatzes mit verkoppelten Schreib(WR(C))- bzw. Ansteuerleitungen (C), verbunden sind.

2. Mehrfach adressierbarer hochintegrierter Halbleiterspeicher nach Anspruch 1, dadurch gekennzeichnet, daß die Anzahl der Lesezugänge über weitere zusätzliche Adreßsysteme und Triple-, Quadrupel- usw. Speicherzellen erweiterbar ausgeführt sind.

3. Speicher bestehend aus mehreren Halbleiterspeichern nach den Ansprüchen 1 bis 2, dadurch gekennzeichnet, daß mit einem Wortleitungspaar (n — 1 (A), (B)) verbundene Zellenpaare (CP) Registerbänke (n — 1, n — 2, ...) bilden, die über getrennte Wortleitungen (WLA, WLB) getrennt ansteuerbar sind und über getrennte Bitleitungspaare ihre Informationen abgeben, und daß zum Einschreiben von Informationen alle zu einer Registerbank gehörenden Zellenpaare (CP) über die beiden Wortleitungen (WLA, WLB) gemeinsam von einem dritten Zugang (C) selektierbar sind.

4. Mehrfach adressierbarer hochintegrierbarer Halbleiterspeicher nach den Ansprüchen 1 und 2, dadurch gekennzeichnet, daß zur parallelen Durchführung der Operationen »Lesen Wort A«, »Lesen Wort B« und »Schreiben Wort C« sowie jeder beliebigen Zweierkombination oder einer einzelnen der drei Operationen die Zellenpaare (CP) mit getrennten Zugängen ((A, (B), (C)) versehen sind.

5. Halbleiterspeicher nach Anspruch 4, dadurch gekennzeichnet, daß der dritte Zugang (C) zum Einschreiben von Informationen in den Speicher über zwei Koppelglieder (KWA, KWB) mit den Wortleitungen (WLA, WLB) der Flip-Flops (FF) verbunden. ist, wodurch beide Zellen (FF) eines Zellenpaares (CP) gleichzeitig über die beiden Wortleitungen und die gemeinsamen Schreibleitungen (WR (C)) angesteuert werden.

6. Halbleiterspeicher nach den Ansprüchen 1, 2 , 4 und 5, dadurch gekennzeichnet, daß die Lesezugänge (R (A), R (B)) der Ausführung in Mehrschicht-Metallisierung innerhalb eines Halbleiter-Chips in einer gemeinsamen Metallisierungsschicht (3.M) angeordnet sind, daß der gemeinsame Schreibzugang (WR C)) in einer anderen Metallschicht (1.M) angeordnet ist und daß die Wortleitungen (WLA, WLB) einer weiteren Metallschicht (2.M) gemeinsam angeordnet sind.

7. Halbleiterspeicher nach den Ansprüchen 1 bis 6, dadurch gekennzeichnet, daß die Speicherelemente (FF) eines Speicherplatzes in getrennten Speichermatrizen angeordnet sind, die logisch über Koppelglieder miteinander verbunden sind.

## Claims

1. Multiadressable highly integrated semiconductor storage, whose storage locations, adressable by adress decoders and comprising at least two single storage elements are located at the crosspoints of word and bit line pairs, and which are addressable by several independent address systems for parallel reading and/or writing, charcterized in that for realizing the read and write functions, the word and bit line pairs are connected through one pair of coupling elements each (KL, (A, B) and KL, (C), respectively) to the single storage elements (FF), that the coupling elements, connected to the bit lines for reading, are opened by respectively raising and lowering the refernece potential of the single storage elements via an address line for reading and the coupling elements, connected to the bit lines for writing, are opened by respectively lowering and raising the reference potential for the single storage elements via an address line for writing, that one such single storage element of a storage location is in each case adressable via adress and read lines (A, R (A)), while the other single storage element of the same storage location is addressable separately therefrom via second address (B) and read lines (R, (B)) for reading, and that the write operation for both single storage elements of a storage location is controlled through at least a third port (C) by changing the reference potential in that the two single storage elements o a storage location are connected to coupled write (WR (C)) and address lines (C).

2. Multiaddressable highly integrated semiconductor storage according to claim 1, characterized in that the number of read ports can be increased by further additional address systems and triple, quadruple, etc., storage cells.

· 3. Storage comprising several semiconductor storages according to claims 1 to 2, characterized in that cell pairs (CP), connected to a word line pair (n — 1 (A), (B)), form register banks (n — 1, n — 2, ...) which are separately adressable via separate word lines (WLA, WLB) and which emit their information via separate bit line pairs, and that for writing information, all cell pairs (CP) belonging to a register bank are jointly selectable from a third port (C) via the two word lines (WLA, WLB).

4. Multiadressable highly integrated semiconductor storage according to claims 1 and 2, characterized in that for executing in parallel the operations »read word A«, »read word B« and »write word C« as well as any arbitrary combination of two or individual ones of the three operations, the cell pairs (CP) are provided with separate ports ((A), (B), C)).

5. Semiconductor storage according to claim 4, characterized in that the third port (C) for writing information into storage is connected to the word lines (WLA, WLB) of the flip-flops (FF) via two coupling elements (KWA, KWB), so that both cells (FF) of a cell pair (CP) are simultaneously addressed via the two word lines and the common write lines (WR (C)).

6. Semiconductor storage according to claims 1, 2, 4 and 5, characterized in that the read ports (R (A), R (B)) in the layout with multi-layer metallization are arranged within a semiconductor chip in a common metallization layer (3.M), that the common write port (WR (C)) is arranged in another metal layer (1.M), and that the word lines (WLA, WLB) of a further metal layer (2.M) are arranged together.

7. Semiconductor storage according to claim 1 to 6, characterized in that the storage elements (FF) of a storage location are arranged in separate storage matrices which are logically connected to each other via coupling elements.

**Revendications**

1. Mémoire à semiconducteur à haute intégration à adressage multiple dont les positions mémoire, sélectionnées à l'aide de décodeurs d'adresse et comportant au moins deux éléments de mémoire séparés, sont situées aux noeuds de croisement des paires de lignes de mot et de bit, sont sélectionnées par de multiples systèmes d'adressage pour lire et/ou écrire en parallèle, caractérisée en ce que pour exécuter des fonctions de lecture et d'écriture, les paires de lignes de mot et de bit sont connectées respectivement via une paire d'éléments de couplage (KL, (A, B) et KL (C)) avec des éléments de mémoire séparés (FF), en ce que lesdits éléments de couplage connectés avec lesdites lignes de bit pour la lecture sont ouverts par la montée et la baisse du potentiel de référence desdits éléments de mémoire séparés via une ligne de commande de lecture et, lesdits éléments de couplage connectés avec lesdites lignes de bit pour l'écriture sont ouverts par la baisse et la montée du potentiel de référence dedits éléments de mémoire séparés via une ligne commande d'écriture, en ce que respectivement un tel élément de mémoire d'une position de mémoire est sélectionné via des primières lignes de sélection et de lecture (A, R, (A)) et l'autre élément de mémoire de la meme position de mémoire est sélectionné séparément via des secondes lignes de sélection et de lecture (B, R, (B)) afin d'extraire l'information stocké et, en ce que ladite opération d'écriture des deux éléments de mémoire séparés d'une meme position de mémoire est commandée, par au moins un troisième pôle (C) en modifiant le potentiel de référence, les deux dits éléments de mémoire séparés d'une meme position de mémoire étant connectés avec des lignes d'écriture (WR (C)) et de commande (C) interconnectées.

2. Mémoire à semiconducteur à haute intégration à adressage multiple selon la revendication 1, caractérisée en ce qu'on peut augmenter le nombre des pôles de lecture en réalisant des systèmes d'adressage supplémentaires et des cellules mémoire comportant trois, quatre éléments et plus.

3. Mémoire constituée de plusieurs mémoires à semiconducteur selon les revendications 1 et 2, caractérisée en ce que des paires de cellules (CP) reliées à une paire de lignes de mot (n — 1 (A), (B) forment des bancs de registres (n — 1, n — 2, ...) sélectionnés séparément via des lignes de mot séparées (WLA, WLB) et, transmettent leur contenu d'information à travers des paires de lignes de bit séparées et, en ce que toutes les paires de cellules (CP) associées à un banc de registres sont sélectionnées ensemble via les deux lignes de mot (WLA, WLB) par un troisième pôle (C).

4. Mémoire à semiconducteur à haute intégration à adressage multiple selon les revendications 1 et 2, caractérisée en ce que, afin d'effectuer de façon parallèle des opérations »lecture du mot A«, »lecture du mot B« et »écriture du mot C«, ainsi que m'importe quelle autre combinaison de deux opérations, ou afin d'effectuer un seule de ces trois opérations, les paires de cellules (CP) comportent des pôles séparés (A, (B), (C).

5. Mémoire à semiconducteur selon la revendication 4, caractérisée en ce que ledit troisième pôle (C) d'écriture est relié avec les lignes de mot (WLA, WLB) dudit élément de mémoire flip-flop (FF) via deux éléments de couplage (KWA, KWB) de sorte que deux éléments (FF) d'une paire de cellules (CP) sont sélectionnées en meme temps via les deux dites lignes de mot et lesdites lignes d'écriture communes (WR (C)).

6. Mémoire à semiconducteur selon les revendications 1, 2, 4 et 5, caractérisé en ce que les pôles d'écriture (R (A), R (B)) selon la forme de réalisation de métallisation à couches multiples dans une microplaquette semiconducttrice, sont disposées dans une couche métallique commune (3.M), en ce que ledit pôle d'écriture commun (WR C) est disposé dans une autre couche métallique (1.m) et lesdites lignes de mot (WLA, WLB) d'une autre couche métallique (2.m) sont disposées ensemble.

7. Mémoire à semiconducteur selon les revendications 1 à 6, caractérisée en ce que lesdits éléments de mémoire (FF) d'une position de mémoire sont disposés dans des matrices de mémoire séparées reliées logiquement via des éléments de couplage.

# FIG. 1

# FIG. 2

## FIG.3

## FIG.5

**SCHNITT Y-Y**

**SCHNITT X-X**

# FIG.4